# EUROPEAN PATENT APPLICATION

(11) **EP 2 858 286 A1**
(43) Date of publication of application: **08.04.2015**
(21) Application number: 13306379.2
(22) Date of filing: 04.10.2013
(51) Int. Cl.: H04L 1/00, H03M 13/37

(54) **Rateless decoding**

(71) Applicant: ALCATEL LUCENT, 92100 Boulogne-Billancourt (FR)
(72) Inventor: Razavi, Rouzbeh, 15 Dublin (IE); Claussen, Holger, 15 Dublin (IE)
(74) Representative: Leppard, Andrew John

(57) **Abstract**

A receiver method, a receiver and a computer program product are disclosed. A rateless decoder method comprises: receiving a plurality of ratelessly encoded data symbols from a rateless encoder; identifying a decoding symbol from the plurality of ratelessly encoded data symbols, the decoding symbol comprising at least a second degree ratelessly encoded data symbol; locating a higher degree symbol from the plurality of ratelessly encoded data symbols, the higher degree symbol comprising at least a third degree ratelessly encoded data symbol; determining whether the higher degree symbol encodes the decoding symbol and, if so, decoding the higher degree symbol to remove the decoding symbol and provide a degree-reduced symbol. In this way, rather than utilising only degree one symbols in decoding and partial decoding of the ratelessly encoded data symbols, second or higher degree symbols may also be used in decoding or partial decoding of the ratelessly encoded data symbols in order to perform degree reduction. This approach leads to much more rapid decoding of the plurality of ratelessly encoded data symbols than when using only first degree symbols.

## Description

### FIELD OF THE INVENTION

The present invention relates to a receiver method, a receiver and a computer program product.

### BACKGROUND

Communications networks exist for the transfer of data between nodes of a network. Communications links are provided between the nodes of the network over which the data between network nodes is transferred. Different protocols exist which define how the data is transferred between the network nodes over the communications links. Various different classifications of nodes exist which may be deployed. Although such networks enable the transfer of data between nodes, unexpected consequences can occur. Accordingly, it is desired to provide an improved technique for transferring data between nodes.

### SUMMARY

According to a first aspect, there is provided a rateless decoder method, comprising: receiving a plurality of ratelessly encoded data symbols from a rateless encoder; identifying a decoding symbol from the plurality of ratelessly encoded data symbols, the decoding symbol comprising at least a second degree ratelessly encoded data symbol; locating a higher degree symbol from the plurality of ratelessly encoded data symbols, the higher degree symbol comprising at least a third degree ratelessly encoded data symbol; determining whether the higher degree symbol encodes the decoding symbol and, if so, decoding the higher degree symbol to remove the decoding symbol and provide a degree-reduced symbol.

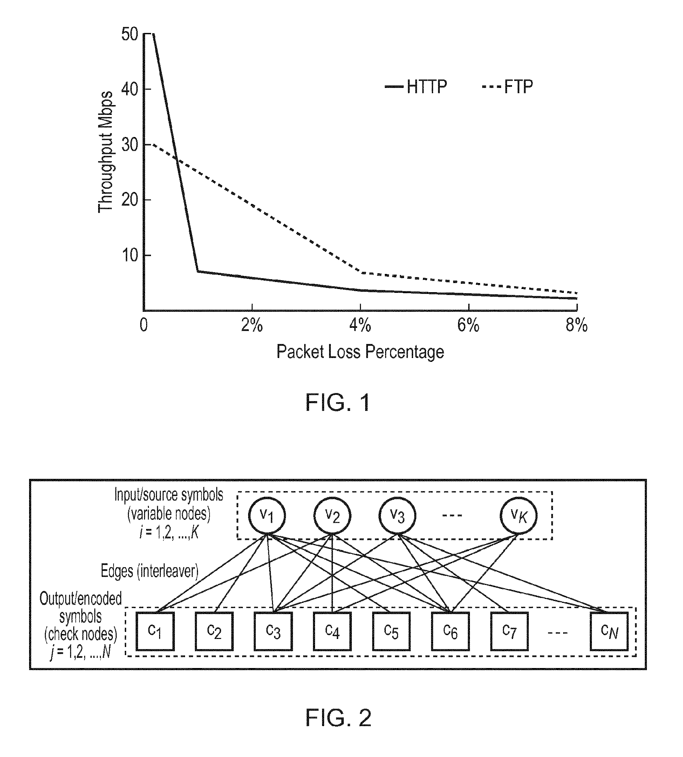

The first aspect recognises that latency is considered as a major concern when it comes to adoption of cloud-based services using networks. Additionally, lack of suitable quality of service (QoS) mechanisms and network underutilisation despite traffic demands results in delay in deployment of cloud-based services. The Transmission Control Protocol (TCP) is currently considered as the main transport protocol. According to research, TCP carries more than 89% of the total traffic world-wide. However, TCP's performance is very sensitive to packet losses and delayed packets. Specifically, the aggressive back-offbehaviour of TCP results in underutilisation of links and increased packet delay. A very recent study suggests a possible 16-fold throughput improvement in networks by modifying TCP behaviour. Figure 1 shows an example of TCP performance in terms of achievable throughput versus packet loss. As illustrated, the throughput drops significantly with small packets' drop rates (that are usual in most networks).

The increased latency as the result of TCP back-off behaviour can be particularly problematic when considering cloud-based services where service level agreement (SLA) violations may result in financial penalties for the cloud provider. Unfortunately, such excessive delays occur more frequently when there is congestion in the network and that's exactly when TCP effects appear most. In addition to congestion, with the significant increase of mobile data usage, wireless links are becoming integrated part of most end-to-end communications. Wireless channels normally result in higher packet drops and hence TCP is known to be very sub-optimal choice for wireless channels (accordingly protocols such as WAP have their own transport protocol, WTP).

Despite these negative sides, TCP is still recognised for its performance reliability. Any other alternative solution should assure reliability of packet delivery without significant bandwidth overheads. As it will be explained, the rateless code based transport protocol is an efficient way to assure reliability while minimising the latency. The end to end protocol has been implemented and measurements indicate that there is a 4-fold throughput improvement (over wired links) and up to 11-fold (over wireless links) when using this transport protocol instead of TCP. These significant improvement gains are in-line with the quantities observed by other very recent research reports.

In addition to the latency, security and, more specifically, data confidentiality is another major concern for wide deployment of many cloud services. As a by-product of the proposed transport control protocol, confidentiality of data when transmitted over untrusted links (for example, over a public network) can be guaranteed.

However, as will be explained, despite of significant performance superiority over TCP, the first aspect recognises that the rateless code based transport protocol suffers a number of issues including inefficient decoding which results in increased overhead when the input batch size is small.

As explained above, although TCP is the most common transport protocol, it suffers from increased latency as a result of aggressive back-offs as well as bandwidth underutilisation. The User Datagram Protocol (UDP), on the other hand, is a transport protocol which does not provide any guarantee on the reliability of the packets' delivery process. Using traditional fixed rate error correction codes is inefficient to combat packet drops (whole packet erasures). Additionally, packet-level error correction codes results in trade-off of bandwidth and reliability and may result in unnecessary utilisation of bandwidth by Forward error correction (FEC) codes. Hybrid automatic repeat request (ARQ) techniques in general are more efficient but their performance significantly depends on optimality of the parameters and reliability of the feedback channels.

Rateless based transport is a very promising way to overcome many issues related to the existing transport protocols. However, the first aspect recognises that rateless codes (such as LT codes) suffer from increased coding overhead when the input batch size is small.

Accordingly, a rateless decoding method is provided. The rateless decoding method may comprise the step of receiving a plurality or group of ratelessly encoded data symbols from a rateless encoder. The method may also comprise the step of identifying a decoding symbol from within the plurality of ratelessly encoded data symbols. The decoding symbol may comprise a second degree or higher ratelessly encoded data symbol from that plurality of ratelessly encoded data symbols. The method may also comprise locating at least one higher degree symbol from the plurality of ratelessly encoded data symbols. The higher degree symbol may comprise a third degree or higher ratelessly encoded data symbol from that plurality of ratelessly encoded data symbols. The method may also comprise the step of determining whether the higher degree symbol encodes the decoding symbol. If the higher degree symbol does encode the decoding symbol, then the method may comprise the step of decoding the higher degree symbol to remove the decoding symbol and generate a degree-reduced symbol. In this way, rather than utilising only degree one symbols in decoding and partial decoding of the ratelessly encoded data symbols, second or higher degree symbols may also be used in decoding or partial decoding of the ratelessly encoded data symbols in order to perform degree reduction. This approach is similar to that used in conventional rateless decoding and does not require the intensive computation of other approaches such as a Gaussian elimination but leads to much more rapid decoding of the plurality ofratelessly encoded data symbols than when using only first degree symbols. In embodiments, the removal of the decoding symbol can be achieved through a simple XOR or modulo-2 operation involving the higher degree symbol and the decoding symbol to leave the degree-reduced symbol.

In one embodiment, the step of locating comprises locating each higher degree symbol from the plurality ofratelessly encoded data symbols and the step of determining comprises determining whether each of those higher degree symbols encodes the decoding symbol and, if so, decoding each higher degree symbol to remove the decoding symbol and provide a corresponding degree-reduced symbol. Accordingly, each or every higher degree symbol may be identified, it may be determined whether those higher degree symbols encode the decoding symbol so that the decoding symbol may be removed to provide a degree-reduced symbol.

In one embodiment, the decoding symbol comprises an 'm'th degree ratelessly encoded data symbol and each higher degree symbol comprises an 'm+1'th degree ratelessly encoded data symbol, where m ≥ 2, the step of locating comprises locating each 'm+1'th degree symbol and the step of determining comprises determining whether each of those 'm+1'th degree symbols encodes the decoding symbol and, if so, decoding each 'm+1'th degree symbol to remove the decoding symbol and provide a corresponding degree-reduced symbol. Accordingly, for any decoding symbol, a higher degree symbol is that which is one degree higher than the decoding symbol. For example, for a second degree decoding symbol, the higher degree symbol would be a third degree symbol, and so on.

In one embodiment, the decoding symbol comprises 'm'th degree ratelessly encoded data symbol and the higher degree symbol comprises an 'm+1+i'th degree ratelessly encoded data symbol, where m ≥ 2, the step of locating comprises locating each 'm+1+i'th degree symbol and the step of determining comprises determining whether each of those 'm+1+i'th degree symbols encodes the decoding symbol and, if so, decoding each 'm+1+i'th degree symbol to remove the decoding symbol and provide a corresponding degree-reduced symbol, where i ≥ 1. Accordingly, as well as determining whether each immediately higher (m+1) degree symbol encodes the decoding symbol, further higher (m+1+i) degree symbols are also located and examined. For example, if the decoding symbol is a second degree symbol then the further higher degree symbols would be the fourth degree symbols onwards. This enables those higher degree symbols to also be degree-reduced.

In one embodiment, the method comprises the step of following the steps of locating and determining for every 'm+1+i'th degree symbol, incrementing i and repeating the steps of locating and determining. Accordingly, after examining each further higher degree symbol, yet further higher degree symbols may also be examined. This would mean that, for example, each fourth degree symbol is examined then, once each of these has been examined, each fifth degree symbol is examined, and so on.

In one embodiment, the method comprises the step of locating a further decoding symbol from the plurality ofratelessly encoded data symbols and repeating the steps of locating and determining.

In one embodiment, the method comprises the step of following the steps of locating and determining for every 'm'th degree ratelessly encoded data symbol, incrementing 'm' and repeating the steps of locating and determining. Hence, once each decoding symbol having a particular degree has been used, then the degree may be increased and each decoding symbol for that increased degree may be used for decoding.

In one embodiment, the method comprises the steps of receiving an indication of a maximum degree 'n' from the rateless encoder and ceasing the steps of locating and determining when m+1+i > n. Accordingly, the encoder can indicate to the decoder the maximum degree to examine.

In one embodiment, the method comprises the steps of receiving encoding parameters from said rateless encoder, deriving a maximum degree 'n' from said encoding parameters and ceasing said steps of locating and determining when m+1+i > n. Hence, the receiver may itself derive the maximum degree of encoded data symbols to examine based on the encoded parameters provided by the encoder.

In one embodiment, the method comprises the steps deriving a maximum degree 'n' from said plurality of ratelessly encoded data symbols and ceasing said steps of locating and determining when m+1+i > n. Hence, the receiver may itself derive the maximum degree of encoded data symbols to examine based on examining the received encoded data symbols themselves.

In one embodiment, the method comprises the steps of receiving an indication of at least one value of 'm+1+i' from the rateless encoder and repeating the steps of locating and determining for each value of 'm+1+i'. Accordingly, the encoder can indicate to the decoder the degrees to examine. For example, the encoder may indicate that the ratelessly encoded data symbols are encoded as mostly third, fifth and sixth degree encoded data symbols then 'm+1+i' is determined to have the values 3, 5 and 7.

In one embodiment, the method comprises the steps of deriving at least one value of 'm+1+i' from the plurality of ratelessly encoded data symbols. Accordingly, the presence of the various higher degree symbols may be determined by the decoder itself by examining the ratelessly encoded data symbols. For example, a histogram representation of the plurality of ratelessly encoded data symbols may be used in conjunction with one or more thresholds above which it can be determined that a significant number of particular higher degree symbols are present.

In one embodiment, the method comprises the steps of deriving a maximum degree 'n' based on resources available to the rateless decoder and transmitting the maximum degree 'n' to the rateless encoder. Accordingly, the decoder may influence the encoding being performed by the encoder by transmitting maximum degree 'n' to the encoder from which it may derive encoding parameters to ensure that no encoded data symbols are generated which exceed the maximum degree 'n'. For example, if the decoder has an increase in the resources available to it to perform the decoding process, then it may indicate to the encoder that an increase in the number of higher degree of ratelessly encoded data symbols can occur.

According to a second aspect, there is provided a rateless decoder, comprising: reception logic operable to receive a plurality of ratelessly encoded data symbols from a rateless encoder; identification logic operable to identify a decoding symbol from the plurality of ratelessly encoded data symbols, the decoding symbol comprising at least a second degree ratelessly encoded data symbol; locating logic operable to locate a higher degree symbol from the plurality of ratelessly encoded data symbols, the higher degree symbol comprising at least a third degree ratelessly encoded data symbol; and determining logic operable to determine whether the higher degree symbol encodes the decoding symbol and, if so, to decode the higher degree symbol to remove the decoding symbol and provide a degree-reduced symbol.

In one embodiment, the locating logic is operable to locate each higher degree symbol from the plurality of ratelessly encoded data symbols and the determining logic is operable to determine whether each of those higher degree symbols encodes the decoding symbol and, if so, to decode each higher degree symbol to remove the decoding symbol and provide a corresponding degree-reduced symbol.

In one embodiment, the decoding symbol comprises an 'm'th degree ratelessly encoded data symbol and each higher degree symbol comprises an 'm+1'th degree ratelessly encoded data symbol, where m ≥ 2, the locating logic is operable to locate each 'm+1'th degree symbol and the determining logic is operable to determine whether each of those 'm+1'th degree symbols encodes the decoding symbol and, if so, to decode each 'm+1'th degree symbol to remove the decoding symbol and provide a corresponding degree-reduced symbol.

In one embodiment, the decoding symbol comprises 'm'th degree ratelessly encoded data symbol and the higher degree symbol comprises an 'm+1+i'th degree ratelessly encoded data symbol, where m ≥ 2, the locating logic is operable to locate each 'm+1+i'th degree symbol and the determining logic is operable to determine whether each of those 'm+1+i'th degree symbols encodes the decoding symbol and, if so, to decode each 'm+1+i'th degree symbol to remove the decoding symbol and provide a corresponding degree-reduced symbol, where i ≥ 1.

In one embodiment, the locating and determining logic is operable following locating and determining for every 'm+1+i'th degree symbol, to increment i and repeating the locating and determining.

In one embodiment, the locating and determining logic is operable to locate a further decoding symbol from the plurality of ratelessly encoded data symbols and to repeating the locating and determining with the further decoding symbol.

In one embodiment, the locating and determining logic is operable following the locating and determining for every 'm'th degree ratelessly encoded data symbol, to increment 'm' and to repeat the locating and determining.

In one embodiment, the reception logic is operable to receive an indication of a maximum degree 'n' from the rateless encoder and the locating and determining logic is operable to cease the locating and determining when m+1+i > n.

In one embodiment, the reception logic is operable to receive encoding parameters from said rateless encoder and the locating and determining logic is operable to derive a maximum degree 'n' from said encoding parameters and to cease the locating and determining when m+1+i > n.

In one embodiment, the locating and determining logic is operable to derive a maximum degree 'n' from said plurality ofratelessly encoded data symbols and to cease the locating and determining when m+1+i > n.

In one embodiment, the reception logic is operable to receive an indication of at least one value of 'm+1+i' from the rateless encoder and the locating and determining logic is operable to repeat the locating and determining for each value of 'm+1+i'.

In one embodiment, the reception logic is operable to derive at least one value of 'm+1+i' from the plurality of ratelessly encoded data symbols.

In one embodiment, the rateless decoder comprises logic operable to deriving a maximum degree 'n' based on resources available to the rateless decoder and to transmit the maximum degree 'n' to the rateless encoder.

According to a third aspect, there is provided a computer program product operable, when executed on a computer, to perform the method steps of the first aspect.

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates an example of TCP performance when packet loss is present;
Figure 2 is a bipartite-graph-based description of an LT code showing the source symbols (variable nodes) and the LT-encoded symbols (check nodes). The symbols can be of an arbitrary size. For instance, c4 is calculated by the modulo-2 sum (XOR product) of v2 and vK in the specific example portrayed in this bipartite graph;
Figure 3 illustrates a comparison of TCP (with CWND=1 in this example) and rateless coding transmission schemes;
Figure 5 illustrates an approximated expected sum of partial decoding events for an example case where K=100;

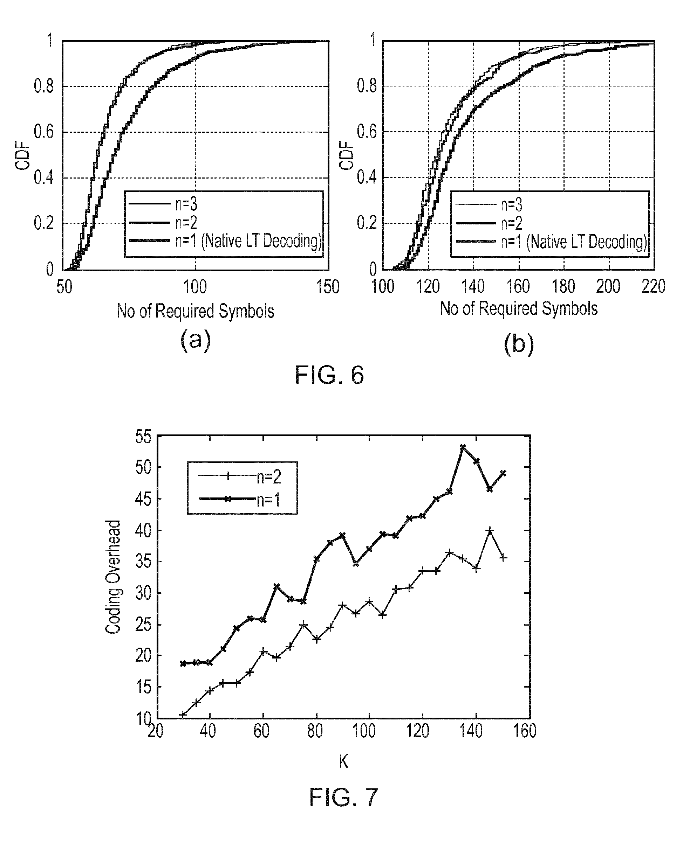

Figure 6 illustrates CDF of number of required encoded symbols for decoding of a) 50 and b) 100 input symbols; and
Figure 7 shows a coding overhead comparison for different values of K.

### DESCRIPTION OF THE EMBODIMENTS

### Overview

Before discussing the embodiments in any more detail, first an overview will be provided. Embodiments provide a mechanism to exploit higher-order (greater than first degree) ratelessly encoded (such as LT-encoded) symbols to assist the decoder to perform partial decoding. In that case, typically all encoded symbols of higher degrees are compared against those that are used for decoding and partial decoding is performed when possible. For example, second degree symbols may be utilised to perform decoding or partial decoding of third degree symbols, then of fourth degree symbols, and so on. Thereafter, third degree symbols may be utilised to perform decoding or partial decoding of fourth degree symbols, then of fifth degree symbols, and so on. More generally, an 'm'th degree symbol may be used to decode or partially decode "m+1+i" degree symbols, where i starts at 0 and is incremented (typically to a maximum amount) when all 'm'th degree symbols have been used in decoding. The maximum degree of encoded symbols that can participate in decoding process can be passed as a parameter between the encoder and decoder in order to limit the resources employed for such decoding and partial decoding. For example, the maximum number of "m+1+i" may be passed between the encoder and decoder in either an explicit or derivable form. This approach introduces very minimal changes to the existing native rateless decoders while offering notable overhead reduction gains (around 33% on average for batch size of 50 symbols). In addition, this approach helps the decoder to empty its buffer faster and, hence, minimizes the buffer requirement at the receiver (decoder). The approach is also very flexible and does not require any change to the encoder.

### Overview of Rateless Codes

The rudimentary principles of the encoding and decoding techniques of rateless coding for transmission over erasure channels will now be explained in more detail. Luby transform (LT) codes are the first practical realization of rateless codes and these will be used to explain the principles of rateless codes (whilst many other implementations/ variants are possible).

### Encoding Procedure

Assume a data message consisting of K input (source) symbols v = [v₁ v₂ ··· v_{K}], with each symbol containing an arbitrary number of bits. The terminology used often refers to the original data message v as a "file". Consider a hypothetical example of a data message containing four two-bit symbols given by the vector v =[00 10 11 01].

The LT-encoded symbols c = [cⱼ],2 j = 1, .., N, are simply the modulo-2 sum (i.e., the exclusive OR (XOR)) of d_{c} distinct input symbols, chosen uniformly at random. The actual d_{c} value (defining the number of input or source symbols to be encoded for each LT-encoded symbol) is chosen from a pre-defined distribution f(d_{c}), which is also sometimes referred to as the output distribution. Assume now that the first d_{c}-value sampled from f(d_{c}) is 2. Consequently, two input symbols will be chosen at random from v. Assume that the two selected source symbols correspond to the first and second symbol in v. In THIS case, c₁ will be calculated as 00 ⊗ 10 = 10, where "⊗" denotes the XOR function.

The encoding algorithm proceeds in the same manner, each time selecting a d_{c}-value sampled pseudo-randomly from f(d_{c}) and then calculating the encoded symbol according to the XOR product of a dc-number ofpseudo-randomly selected source symbols. Sometimes the encoded symbols are referred to as the "LT-encoded packets" due to the natural applicability of LT codes to the communication channels.

The connection between the input and output symbols can also be diagrammatically represented by means of a bipartite graph, as shown in Figure 2. Using graph-related terminology, the input source symbol may be referred to as a variable node, whilst the LT-encoded symbol can be regarded as a check node. The number of edges emerging from each check node corresponds to the d_{c}-value sampled from f(d_{c}) and for this reason, d_{c} is sometimes referred to as the check degree.

### Decoding Procedure

Now consider an erasure channel, in which encoded symbols of c are erased during the ensuing transmission. Simplistically speaking, the task of the decoder is that of recovering the erased symbols from the unerased ones. The decoding process typically commences by locating a degree-one input symbol; i.e., a symbol that is not XOR-combined with any other. The decoder will then modulo-2 add the value of this symbol to all the LT-encoded symbols relying on it and then removes the corresponding modulo-2 connections, where each connection is represented by an edge on the associated bipartite graph (see Figure 2). The decoding procedure continues in an iterative manner, each time starting from a degree-one symbol or a newly decoded symbol.

### Rateless codes with Feedback

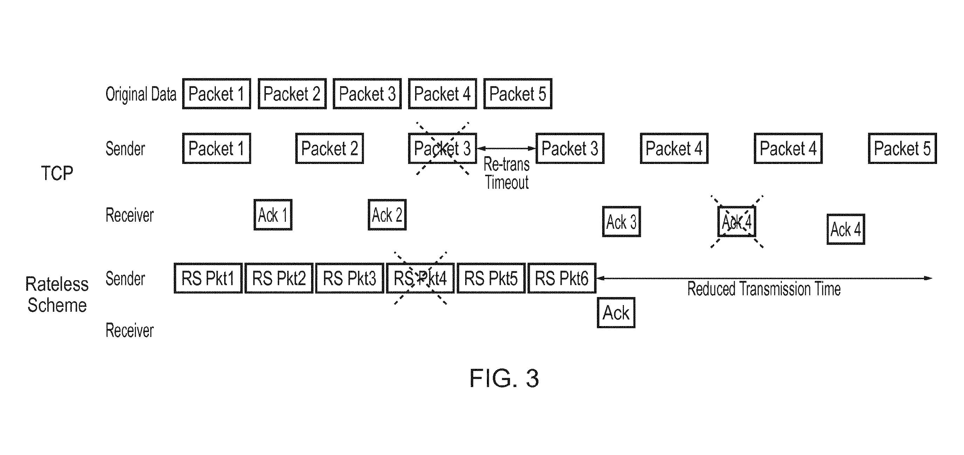

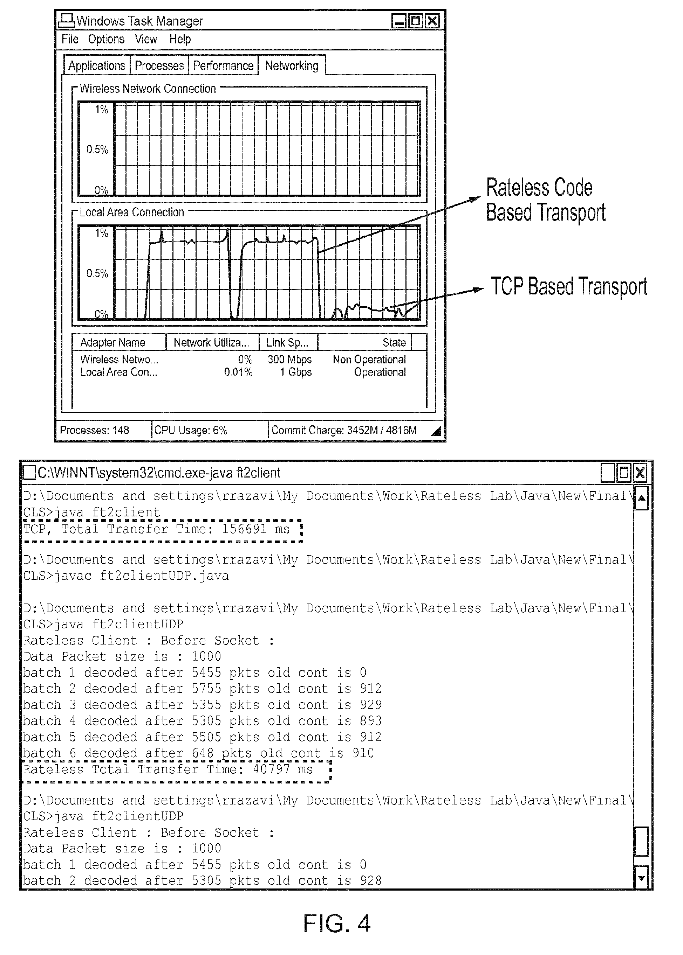

With an efficient implementation, any N original packets can be decoded using any N rateless coded packets with a high probability (in practice there is normally a marginal overhead). This is particularly important since it removes the requirement for the sender to retransmit a data packet that is dropped or received with uncorrectable errors (if error correction codes are in use). Instead, the sender can continue transmitting rateless coded packets until N packets are received. At this point the receiver can send a single acknowledgment packet to allow the sender to move on to the next group of packets. This can significantly improve the latency of the transmission compared to TCP (especially under congestion conditions when TCP congestion window is small). Figure 3 shows a schematic example comparing TCP and a transmission scheme based on rateless codes.

In this rateless codes scheme, the number ofpackets involved in each batch or group should be decided and communicated with the receiver. This rateless code based transport protocol will be very similar to the UDP, in that the transmitter will send data packets consequently. However, once enough correct packets are revived or decoded at the receiver side, it will send an acknowledgment and the transmitter can move on to the next batch or group. If the size of the batch or group is changed, it should be communicated with the receiver. It should be noted that all rateless coded packets contain mapping information in respect to the original packets. In Figure 3 for example, RS Pkt 1 might be result of the XOR operation of original packets 5 and 3. Since each batch of rateless coded packets covers a certain range of original packets, the receiver can easily tell each received packets belongs to which batch. Optionally, each packet can contain the batch ID.

In addition, due to the random nature of the rateless coding, it is possible that some coded packets are duplicated or some specific packets are missing in a given number of coded packets. Therefore, in practice some overhead may be required in order to assure successful decoding of rateless coded packets.

### Performance of the rateless code based transport protocol

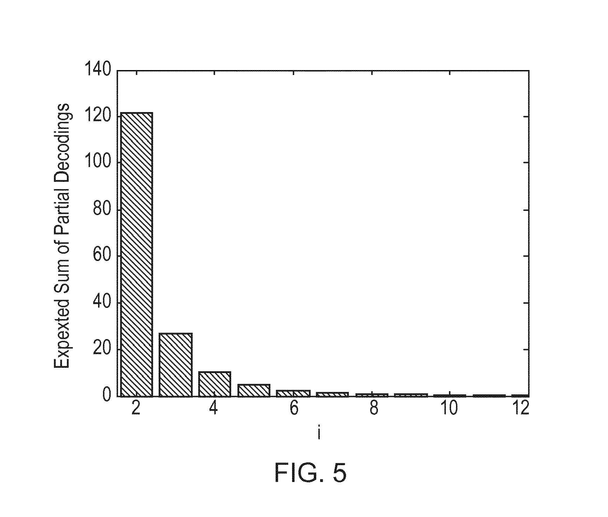

To examine the feasibility and to evaluate the performance gains of the above described transport protocol based on rateless codes, the full the end-to-end transport solution was implemented. Compared to the traditional TCP based transport, the new scheme provides a throughput gain of about 4-times when considering wired links and up to 11-times when the communication path consists of wireless links. Such enormous gains are very promising, making the adoption of this scheme to be likely in near future. Figure 5 shows some snapshots comparing the TCP based data transport with the new scheme for a wired communication scenario. In this example, a file transfer was used as a case study for comparison of throughput of the two schemes.

Despite all their advantages which have made them applicable to a wide range of communication scenarios, LT codes suffer from increased coding overhead when the number of input symbols, K, is small. Unfortunately, many practical scenarios may require the number of input symbols to be restricted to avoid high packets latency and increased buffer space requirement both at the encoder and decoder sides.

Different approaches have attempted to address this issue. In one approach, the configuration of degree distribution of LT codes was optimised specifically for small K. The optimisation aims to minimise the average number of symbols required for successful decoding of input symbols and simultaneously to maximise the probability of successful decoding with exactly K encoded symbols. However, this method is only applicable to scenarios when K is very small (<30). In addition, this method requires modification of both encoder and decoder. Another approach uses a new degree distribution and deploys Gaussian elimination for decoding. Unfortunately, Gaussian elimination results in significant increase of decoding complexity. A further approach uses a Wiedemann algorithm for LT decoding which is not a natural extension of the native LT decoding.

Native LT decoding tries to locate a degree one packet (i.e. a packet or symbol which is not encoded with another) and uses that to fully or partially decode remaining encoded symbols. The procedure continues iteratively until all symbols are decoded or otherwise halts when the decoder is unable to find a degree one packet that can result in further decoding progress. This may result in premature termination of the decoding process.

Consider a very simplified example in that a set of input symbols U={u1 u2 u3} are mapped into a set of encoded symbols V= {v1 v2 v3} where v₁ = u₁ ⊗u₂ ⊗u₃,

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/ or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A rateless decoder method, comprising:
receiving a plurality of ratelessly encoded data symbols from a rateless encoder;
identifying a decoding symbol from said plurality of ratelessly encoded data symbols, said decoding symbol comprising at least a second degree ratelessly encoded data symbol;
locating a higher degree symbol from said plurality of ratelessly encoded data symbols, said higher degree symbol comprising at least a third degree ratelessly encoded data symbol;
determining whether said higher degree symbol encodes said decoding symbol and, if so, decoding said higher degree symbol to remove said decoding symbol and provide a degree-reduced symbol.

2. The method of claim 1, wherein said step of locating comprises locating each higher degree symbol from said plurality of ratelessly encoded data symbols and said step of determining comprises determining whether each of those higher degree symbols encodes said decoding symbol and, if so, decoding each higher degree symbol to remove said decoding symbol and provide a corresponding degree-reduced symbol.

3. The method of claim 1 or 2, wherein said decoding symbol comprises an 'm'th degree ratelessly encoded data symbol and each higher degree symbol comprises an 'm+1'th degree ratelessly encoded data symbol, where m ≥ 2, said step of locating comprises locating each 'm+1'th degree symbol and said step of determining comprises determining whether each of those 'm+1'th degree symbols encodes said decoding symbol and, if so, decoding each 'm+1'th degree symbol to remove said decoding symbol and provide a corresponding degree-reduced symbol.

4. The method of any preceding claim, wherein said decoding symbol comprises 'm'th degree ratelessly encoded data symbol and said higher degree symbol comprises an 'm+1+i'th degree ratelessly encoded data symbol, where m ≥ 2, said step of locating comprises locating each 'm+1+i'th degree symbol and said step of determining comprises determining whether each of those 'm+1+i'th degree symbols encodes said decoding symbol and, if so, decoding each 'm+1+i'th degree symbol to remove said decoding symbol and provide a corresponding degree-reduced symbol, where i ≥ 1.

5. The method of any preceding claim, comprising the step of following said steps of locating and determining for every 'm+1+i'th degree symbol, incrementing i and repeating said steps of locating and determining.

6. The method of any preceding claim, comprising the step of locating a further decoding symbol from said plurality of ratelessly encoded data symbols and repeating said steps of locating and determining.

7. The method of any preceding claim, comprising the step of following said steps of locating and determining for every 'm'th degree ratelessly encoded data symbol, incrementing 'm' and repeating said steps of locating and determining.

8. The method of any preceding claim, comprising the steps of receiving an indication of a maximum degree 'n' from said rateless encoder and ceasing said steps of locating and determining when m+1+i > n.

9. The method of any preceding claim, comprising the steps of receiving encoding parameters from said rateless encoder, deriving a maximum degree 'n' from said encoding parameters and ceasing said steps of locating and determining when m+1+i > n.

10. The method of any preceding claim, comprising the steps deriving a maximum degree 'n' from said plurality of ratelessly encoded data symbols and ceasing said steps of locating and determining when m+1+i > n.

11. The method of any preceding claim, comprising the steps of receiving an indication of at least one value of 'm+1+i' from said rateless encoder and repeating said steps of locating and determining for each value of 'm+1+i'.

12. The method of any preceding claim, comprising the steps of deriving at least one value of 'm+1+i' from said plurality of ratelessly encoded data symbols.

13. The method of any preceding claim, comprising the steps of deriving a maximum degree 'n' based on resources available to said rateless decoder and transmitting said maximum degree 'n' to said rateless encoder.

14. A rateless decoder, comprising:
reception logic operable to receive a plurality ofratelessly encoded data symbols from a rateless encoder;
identification logic operable to identify a decoding symbol from said plurality of ratelessly encoded data symbols, said decoding symbol comprising at least a second degree ratelessly encoded data symbol;
locating logic operable to locate a higher degree symbol from said plurality of ratelessly encoded data symbols, said higher degree symbol comprising at least a third degree ratelessly encoded data symbol; and
determining logic operable to determine whether said higher degree symbol encodes said decoding symbol and, if so, to decode said higher degree symbol to remove said decoding symbol and provide a degree-reduced symbol.

15. A computer program product operable, when executed on a computer, to perform the method steps of any one of claims 1 to 11.

## Amended claims

### Amended claims in accordance with Rule 137(2) EPC.

1. A rateless decoder method, comprising:
receiving a plurality of ratelessly encoded data symbols (c₁ - c_{N})from a rateless encoder;
identifying a decoding symbol from said plurality of ratelessly encoded data symbols, said decoding symbol comprising at least a second degree ratelessly encoded data symbol;
locating a higher degree symbol from said plurality of ratelessly encoded data symbols, said higher degree symbol comprising at least a third degree ratelessly encoded data symbol;
determining whether said higher degree symbol encodes said decoding symbol and, if so, decoding said higher degree symbol using said decoding symbol to remove said decoding symbol and provide a degree-reduced symbol.

2. The method of claim 1, wherein said step of locating comprises locating each higher degree symbol from said plurality of ratelessly encoded data symbols and said step of determining comprises determining whether each of those higher degree symbols encodes said decoding symbol and, if so, decoding each higher degree symbol to remove said decoding symbol and provide a corresponding degree-reduced symbol.

3. The method of claim 1 or 2, wherein said decoding symbol comprises an `m'th degree ratelessly encoded data symbol and each higher degree symbol comprises an 'm+1'th degree ratelessly encoded data symbol, where m ≥ 2, said step of locating comprises locating each 'm+1'th degree symbol and said step of determining comprises determining whether each of those 'm+1'th degree symbols encodes said decoding symbol and, if so, decoding each 'm+1'th degree symbol to remove said decoding symbol and provide a corresponding degree-reduced symbol.

4. The method of any preceding claim, wherein said decoding symbol comprises 'm'th degree ratelessly encoded data symbol and said higher degree symbol comprises an 'm+1+i'th degree ratelessly encoded data symbol, where m ≥ 2, said step of locating comprises locating each 'm+1+i'th degree symbol and said step of determining comprises determining whether each of those 'm+1+i'th degree symbols encodes said decoding symbol and, if so, decoding each 'm+1+i'th degree symbol to remove said decoding symbol and provide a corresponding degree-reduced symbol, where i ≥ 1.

5. The method of any preceding claim, comprising the step of following said steps of locating and determining for every 'm+1+i'th degree symbol, incrementing i and repeating said steps of locating and determining.

6. The method of any preceding claim, comprising the step of locating a further decoding symbol from said plurality of ratelessly encoded data symbols and repeating said steps of locating and determining.

7. The method of any preceding claim, comprising the step of following said steps of locating and determining for every 'm'th degree ratelessly encoded data symbol, incrementing 'm' and repeating said steps of locating and determining.

8. The method of any preceding claim, comprising the steps of receiving an indication of a maximum degree 'n' from said rateless encoder and ceasing said steps of locating and determining when m+1+i > n.

9. The method of any preceding claim, comprising the steps of receiving encoding parameters from said rateless encoder, deriving a maximum degree 'n' from said encoding parameters and ceasing said steps of locating and determining when m+1+i > n.

10. The method of any preceding claim, comprising the steps deriving a maximum degree 'n' from said plurality of ratelessly encoded data symbols and ceasing said steps of locating and determining when m+1+i > n.

11. The method of any preceding claim, comprising the steps of receiving an indication of at least one value of 'm+1+i'from said rateless encoder and repeating said steps of locating and determining for each value of 'm+1+i'.

12. The method of any preceding claim, comprising the steps of deriving at least one value of 'm+1+i' from said plurality of ratelessly encoded data symbols.

13. The method of any preceding claim, comprising the steps of deriving a maximum degree 'n' based on resources available to said rateless decoder and transmitting said maximum degree 'n' to said rateless encoder.

14. A rateless decoder, comprising:
reception logic operable to receive a plurality of ratelessly encoded data symbols (c₁ - c_{N}) from a rateless encoder;
identification logic operable to identify a decoding symbol from said plurality of ratelessly encoded data symbols, said decoding symbol comprising at least a second degree ratelessly encoded data symbol;
locating logic operable to locate a higher degree symbol from said plurality of ratelessly encoded data symbols, said higher degree symbols comprising at least a third degree ratelessly encoded data symbol; and
determining logic operable to determine whether said higher degree symbol encodes said decoding symbol and, if so, to decode said higher degree symbol using said decoding symbol to remove said decoding symbol and provide a degree-reduced symbol.

15. A computer program product operable, when executed on a computer, to perform the method steps of any one of claims 1 to 11.
